(19) **Europäisches Patentamt**
**European Patent Office**
**Office européen des brevets**

(11) **EP 1 909 317 A1**

(12) **EUROPEAN PATENT APPLICATION**
published in accordance with Art. 153(4) EPC

(43) Date of publication:
**09.04.2008 Bulletin 2008/15**

(51) Int Cl.:
**H01L 21/60** (2006.01)   **C22C 5/02** (2006.01)

(21) Application number: **06766498.7**

(22) Date of filing: **08.06.2006**

(86) International application number:
**PCT/JP2006/311525**

(87) International publication number:
**WO 2006/134825 (21.12.2006 Gazette 2006/51)**

(84) Designated Contracting States:
**DE FR GB IT NL**

(30) Priority: **14.06.2005 JP 2005173726**

(71) Applicant: **TANAKA DENSHI KOGYO KABUSHIKI KAISHA**
**Tokyo 100-6422 (JP)**

(72) Inventors:
• **MAKI, Kazunari, Mitsubishi Materials Corporation**
**Sanda-shi, Hyogo 669-1339 (JP)**
• **NAKATA, Yuji, Mitsubishi Materials Corporation**
**Sanda-shi, Hyogo 669-1339 (JP)**

(74) Representative: **HOFFMANN EITLE**
**Patent- und Rechtsanwälte**
**Arabellastrasse 4**
**81925 München (DE)**

(54) **GOLD ALLOY WIRE FOR USE AS BONDING WIRE EXHIBITING HIGH INITIAL BONDING CAPABILITY, HIGH BONDING RELIABILITY, HIGH CIRCULARITY OF PRESS BONDED BALL, HIGH STRAIGHT ADVANCING PROPERTY, HIGH RESIN FLOW RESISTANCE AND LOW SPECIFIC RESISTANCE**

(57) There are provided a gold alloy wire for a bonding wire having high initial bonding ability, high bonding reliability, high roundness of a compression ball, high straightness, high resin flowability resistance, and low specific resistance. The gold alloy wire having high initial bonding ability, high bonding reliability, high roundness of a compression ball, high straightness, high resin flowability resistance, and low specific resistance contains one or more of Pt and Pd of 500 to less than 1000 ppm in total, Ir of 1 to 100 ppm, Ca of more than 30 to 100 ppm, Eu of more than 30 to 100 ppm, Be of 0.1 to 20 ppm, if necessary, one or more of La, Ba, Sr, and Bi of 30 to 100 ppm in total, if necessary, and a balance being Au and inevitable impurities.

**Description**

TECHNICAL FIELD

The present invention relates to a gold alloy wire for a bonding wire that is used to connect a chip electrode of a semiconductor element such as a transistor, LSI, or IC to an external lead part and has high initial bonding ability, high bonding reliability, high roundness of a compression ball, high straightness, high resin flowability resistance, and low specific resistance. In particular, the invention relates to a gold alloy wire for wire bonding that can be used in a wide temperature range from low temperature to high temperature (for example, in the range of -20 to 60°C) and has a diameter less than 20 μm.

BACKGROUND ART

An ultrasonic wave combined thermal compression bonding is performed for a gold alloy wire for a bonding wire in order to connect an electrode on an IC chip to an external lead part. A gold alloy wire having the following composition has been known as a gold alloy wire for a bonding wire used in this case. The composition of the gold alloy wire includes at least one of Pd, Pt, Rh, Ir, Os, and Ru of 3 to 1000 ppm, Eu of 1 to 30 ppm, at least one of Be, Ca, Ge, and Sr of 1 to 30 ppm, and a balance being Au and inevitable impurities (see patent reference 1).
[Patent Reference 1]
Japanese Unexamined Patent Application, First Publication No. Hei 08-109425

DISCLOSURE OF INVENTION

PROBLEMS TO BE SOLVED BY THE INVENTION

Recently, as the integration of the semiconductor elements has increased, an Al pad area becomes small and a substrate having a low heat resistance has been used. As a result, it is required to obtain excellent initial bonding ability (resistance in separation of compression balls from the Al pad during the bonding of balls onto the Al pad) with a lower temperature and smaller area than those of the related art.
In addition, the decrease of bonding strength due to a ball bonding or the occurrence of bonding failures due to a rise of electrical resistance in the bonding interface has caused problems in an automobile IC for requiring a high reliability at the severe use environments of a high-temperature and a high frequency IC in which the operating temperature is increased. Since the bonding failure is apt to gradually occur due to the deterioration of bonding conditions, such as a low temperature joint or a shrinking of the bonding areas, it is required to ensure the bonding reliability (persistence of the bonding strength or electrical resistance due to the ball bonding in the bonding interface at some environments) higher than that of the related art.
In addition, the roundness of the compression balls is low at the ball bonding, a portion of the compression balls are protruded from the Al pad, and a short failure occurs by the contact of a neighboring compression ball. Since the contact failure is increasingly apt to occur by the shrinking of the Al pad area and a bonding pad pitch, it is required that the roundness of the compression ball is higher than that of the related art compression ball.
Furthermore, meanwhile, at the same time the length of a wire loop (hereinafter, referred to as a loop length) for joining the chip electrodes of the semiconductor devices to the outer lead becomes long, the distance between the wire loop and a neighboring loop parallel to the wire loop becomes narrow. In order to cope with the above-described states, it is required to make the diameter of the gold alloy wire used as a bonding wire increasingly thin. However, when the diameter of the gold alloy wire is reduced, when the coiled gold alloy wire is extracted from a spool, a curling or meandering (curvature or bending) may easily occur in the gold alloy wire. When the bonding is conducted by using the gold alloy wire in which the curling or meandering (curvature or bending) exists, since the neighboring bonding wire contacts and a short occurs, the bad semiconductor chips are produced to reduce the yield ratio. More particularly, when the diameter of the bonding wire made of the gold alloy is less than 20 μm, the curling or meandering (curvature or bending) may easily occur in the wire directly after being unreeled from the spool. The property of which the loop formed by the bonding without the occurrence of the curling or meandering (curvature or bending) in the wire directly after being unreeled from the spool does not contact to the neighboring loop is referred to as the straightness. When the straightness is insufficient, since the loop contacts to the neighboring loop and shorts out, the bad semiconductor devices are produce to reduce the yield ratio.
In addition, the loop is formed by bonding the wire, and then being molded by the resin. However, at this time, when the bonding wire is influenced by the resin, since the bonding wire contacts to the neighboring loop and shorts out, the bad semiconductor devices are produced to reduce the yield ratio. With respect to the resin flow, when the diameter of the related art gold alloy wire for the bonding wire is 25 μm or 30 μm, the resin flow is hardly problem.

However, as the high integration of the semiconductor devices increases, the distance of the chip electrodes of the semiconductor devices becomes narrow. In order to cope with the high integration of the semiconductor devices, the bonding is performed by using the wire having the thin diameter. However, when the wire diameter is less than 20 μm, the loop is easily influenced during the molding of the resin. Accordingly, it is necessary to have the property (hereinafter, referred to as resin flowability resistance) of which the resin flow is difficult to produce, even though the wire has a thin diameter.

Even though a gold alloy wire for the bonding wire in which the above-mentioned severe conditions are improved is obtained, the resistance of the gold alloy wire is desirable so as to be low in terms of heat or high frequency driving. In particular, as described above, as the integration of the semiconductor elements has increased, the diameter of the gold alloy wire becomes smaller and a loop becomes longer. As a result, the resistance of the gold alloy wire tends to be long. Therefore, there has been a demand for a gold alloy wire for a bonding wire that has a low specific resistance and satisfies the above-mentioned characteristics.

For the above-mentioned difficult demand, the gold alloy wire for the bonding wire described in patent reference 1 has problems in that a work hardening ability of a free-air ball is low and initial bonding ability is low. For this reason, it has not been possible to obtain a gold alloy wire for a bonding wire that can cope with the recent above-mentioned demand. An object of the invention is to provide a more excellent gold alloy wire for a bonding wire having high initial bonding ability, high bonding reliability, high roundness of a compression ball, high straightness, high resin flowability resistance, and low specific resistance.

MEANS FOR SOLVING THE PROBLEMS

The inventors have done research so as to develop a gold alloy wire for a bonding wire having high initial bonding ability, high bonding reliability, high roundness of a compression ball, high straightness, high resin flowability resistance, and low specific resistance. The results obtained by the research are as follows:

(A) A gold alloy wire has a component composition comprising one or more of Pt and Pd of 500 to less than 1000 ppm in total, Ir of 1 to 100 ppm, and Ca of more than 30 to 100 ppm and Eu of more than 30 to 100 ppm, which are more than those of the gold alloy wire for the bonding wire in the related art in a high-purity gold having purity of 99.999% by mass. The above gold alloy wire has high initial bonding ability, high bonding reliability, high roundness of a compression ball, high straightness, high resin flowability resistance, and low specific resistance.

(B) The gold alloy wire having the composition described in (A) further comprises Be of 0.1 to 20 ppm. Since Be distorts a crystal lattice of Au to increase the mechanical strength of the gold alloy wire for the bonding wire and the work hardening ability of a free-air ball and lowers a re-crystallizing temperature, it is possible to raise the height of a loop. As a result, since it is possible to obtain the proper height of a loop, Be can be added, if necessary.

(C) The gold alloy wire having the composition described in (B) further comprises one or more of La, Ba, Sr, and Bi of 30 to 100 ppm in total. Since the mechanical strength of the gold alloy wire for the bonding wire and the work hardening ability of a free-air ball are increased and a re-crystallizing temperature is raised in the gold alloy wire, it is possible to reduce the height of loop of the gold alloy wire.

(D) Even though Ag of 1 to 10 ppm is contained in the gold alloy wire that is described in (A) to (C) and has high initial bonding ability, high bonding reliability, high roundness of a compression ball, high straightness, high resin flowability resistance, and low specific resistance, it has little influence on the properties.

The invention based on the above-described research results is as follows:

(1) A gold alloy wire for a bonding wire having high initial bonding ability, high bonding reliability, high roundness of a compression ball, high straightness, high resin flowability resistance, and low specific resistance has a component composition comprising one or more of Pt and Pd of 500 to less than 1000 ppm in total, Ir of 1 to 100 ppm, Ca of more than 30 to 100 ppm, Eu of more than 30 to 100 ppm, and a balance being Au and inevitable impurities.

(2) A gold alloy wire for a bonding wire having high initial bonding ability, high bonding reliability, high roundness of a compression ball, high straightness, high resin flowability resistance, and low specific resistance has a component composition comprising one or more of Pt and Pd of 500 to less than 1000 ppm in total, Ir of 1 to 100 ppm, Ca of more than 30 to 100 ppm, Eu of more than 30 to 100 ppm, Be of 0.1 to 20 ppm, and a balance being Au and inevitable impurities.

(3) A gold alloy wire for a bonding wire having high initial bonding ability, high bonding reliability, high roundness of a compression ball, high straightness, high resin flowability resistance, and low specific resistance has a component composition comprising one or more of Pt and Pd of 500 to less than 1000 ppm in total, Ir of 1 to 100 ppm, Ca of more than 30 to 100 ppm, Eu of more than 30 to 100 ppm, Be of 0.1 to 20 ppm, one or more of La, Ba, Sr, and Bi of 30 to 100 ppm in total, and a balance being Au and inevitable impurities.

(4) The gold alloy wire having high initial bonding ability, high bonding reliability, high roundness of a compression ball, high straightness, high resin flowability resistance, and low specific resistance described in any one of (1) to (3) may further comprise Ag of 1 to 10 ppm. In a method of manufacturing a gold alloy wire for a bonding wire for annealing gold alloy wire materials obtained by conducting a drawing process the gold alloy wire materials having the component compositions described in (1) to (4) so as to have a predetermined diameter, when 0.2% proof strength (Pa) of the gold alloy wire for the bonding wire is $\sigma_{0.2}$, Young's modulus (Pa) is E, and fracture elongation percentage is $E_L$, it may manufacture the gold alloy wire for the bonding wire satisfying the following equations under an annealing temperature of 550°C or less which is lower than the related art annealing temperature:

$$E \geq 75 \ GPa,$$

$$(\sigma_{0.2}/E) \geq 2.2 \times 10^{-3},$$

and

$$2\% \leq E_L \leq 10\%$$

It is more preferable that a reduction ratio by one die during the drawing process is 5% or less which is lower than the related art reduction ratio. The gold alloy wire for the bonding wire for satisfying the above-described conditions has higher straightness and higher resin flowability resistance.

Accordingly, according to the invention,

(5) when 0.2% proof strength (Pa) of the gold alloy wire for the bonding wire is $\sigma_{0.2}$, Young's modulus (Pa) is E, and fracture elongation percentage is $E_L$, the gold alloy wire having high initial bonding ability, high bonding reliability, high roundness of a compression ball, high straightness, high resin flowability resistance, and low specific resistance described in any one of (1) to (4) satisfies the following equations:

$$E \geq 75 \ GPa,$$

$$(\sigma_{0.2}/E) \geq 2.2 \times 10^{-3},$$

and

$$2\% \leq E_L \leq 10\%$$

Hereinafter, the reason why the component composition of the gold alloy wire for the bonding wire according to the invention having high initial bonding ability, high bonding reliability, high roundness of a compression ball, high straightness, high resin flowability resistance, and low specific resistance is limited as described above will be explained.

[I] Component Composition

   (a) Pt and Pd:

   Both Pt and Pd, which form a complete solid solubility with Au, cause the deterioration of the bonding strength of the compression ball and Al pad to inhibit and improve the bonding reliability. The layered-shape phase including Pt or Pd is formed in the vicinity of a bonding interface to act as a layer (so called, barrier layer with respect to Au diffusion) for decreasing a diffusion velocity of Au, thereby inhibiting the generating velocity of voids generating in the bonding part in accordance with the diffusion of Au. Accordingly, it is considered that Pt and Pd inhibit the deterioration of the bonding strength of the compression ball and Al pad and improve the bonding reliability. As the amount of Pt or Pd is rich, the effect for inhibiting (improving the bonding reliability) the deterioration of the bonding strength grows higher. However, when the total amount of one or more of Pt and Pd is less than 500 ppm, the effect for inhibiting the deterioration of the bonding strength is not obtained. Meanwhile, when the total amount of one or more of Pt and Pd is larger than 1000 ppm, the resistance of the gold alloy is raised. For this reason, it is not preferable that the total amount of one or more of Pt and Pd be less than 500 ppm or 1000 ppm or larger. Accordingly, the total amount of one or more of Pt and Pd is set within the range of 500 to less than 1000 ppm.

(b) Ir:

Ir inhibits the growth of grains (coarsening of grains). For this reason, when forming a free-air ball, it prevents the grain of a wire part (heat-affected part) directly on the ball from being coarsened due to the effect of heat on the ball, and the solidified free-air ball is formed from a great number of fine grains. In addition, the compression ball evenly extends in a radial pattern, and the roundness of the compression ball is improved. However, when the amount of Ir is less than 1 ppm, it may not obtain a predetermined effect. Meanwhile, when the amount of Ir is larger than 100 ppm in the gold alloy wire for the bonding wire containing one or more of Pt and Pd of 500 to less than 1000 ppm in total, the effects are saturated and are not apparently improved, thus causing IC chips to destruct or impair. For this reason, it is not preferable that the amount of Ir be less than 1 ppm and larger than 100 ppm. Accordingly, the amount of Ir is set within the range of 1 to 100 ppm.

(c) Ca:

Ca which is an alkali earth metal and has the metal bond radius larger than that of Au distorts the crystal lattice of Au, thereby increasing the mechanical strength of the gold alloy wire for the bonding wire and work hardening ability of the free-air ball, raising the re-crystallizing temperature, and lowering the height of loop of the gold alloy wire. However, when the amount of Ca is less than 30 ppm, since the work hardening ability is lowered, thereby lowering the initial bonding ability. In addition, the strength is low, it is difficult to satisfy the conditions of $E \geq 75$ GPa, $(\sigma_{0.2}/E) \geq 2.2 \times 10^{-3}$, and $2\% \leq E_L \leq 10\%$. Therefore, the straightness and resin flowability resistance are lower. Meanwhile, when the amount of Ca is larger than 100 ppm, a quantity of oxides is generated on the surface of a free-air ball during the bonding of balls, and large shrinkage holes, which do not contribute to the bonding, are formed at the bottom-center of the free-air ball. Since the initial bonding ability of the ball bonding is lowered, it is not preferable that the amount of Ca be 30 ppm or less or larger than 100 ppm. Accordingly, the amount of Ca is set within the range of more than 30 to 100 ppm.

(d) Eu:

Eu which is a rare earth metal and has the metal bond radius larger than that of Au distorts the crystal lattice of Au, thereby increasing the mechanical strength of the gold alloy wire for the bonding wire and the work hardening ability of free-air ball, raising the re-crystallizing temperature, and lowering the height of loop of the gold alloy wire. In addition, since Eu has a metal bonding radius significantly larger than other metals, the above-mentioned effect is significant in the gold alloy wire for the bonding wire having a small diameter (in particular, diameter less than 20 $\mu$m). However, when the amount of Eu is 30 ppm or less, the work hardening ability is lowered, thereby lowering the initial bonding ability. Further, since the strength is lower, it is difficult to satisfy the conditions of $E \geq 75$ GPa, $(\sigma_{0.2}/E) \geq 2.2 \times 10^{-3}$, and $2\% \leq E_L \leq 10\%$. Therefore, the straightness and resin flowability resistance are lower. Meanwhile, when the amount of Eu is larger than 100 ppm, a quantity of oxides is generated on the surface of free-air ball during the bonding of balls, and large shrinkage holes, which do not contribute to the bonding, are formed at the bottom-center of the free-air ball. Since the initial bonding ability of the ball bonding is lowered, it is not preferable that the amount of Eu be 30 ppm or less and larger than 100 ppm. Accordingly, the amount of Eu is set within the range of more than 30 to 100 ppm.

(e) Be:

Be has the metal bond radius smaller than that of Au and distorts the crystal lattice of Au, thereby increasing the mechanical strength of the gold alloy wire for the bonding wire and the work hardening ability of free-air ball. In a case of containing Be together with Ca and Eu, since the re-crystallizing temperature lowers and the height of loop rises to realize the proper height of loop, it is possible to add, if necessary. However, when the amount of Be is less than 0.1 ppm, it may not obtain a predetermined effect. Meanwhile, when the amount of Be is larger than 20 ppm, a quantity of oxides is generated on the surface of free-air ball during the bonding of balls, large shrinkage holes, which do not contribute to the bonding, are formed at the bottom-center of the free-air ball. Accordingly, the initial bonding ability of the ball bonding is lowered and the size of grains of the directly upper part of ball and the ball part increases, thus deteriorating the roundness of the compression ball part. For this reason, it is not preferable that the amount of Be be less than 0.1 ppm and larger than 20 ppm. Accordingly, the amount of Be is set within the range of 0.1 to 20 ppm.

(f) La, Ba, Sr, and Bi:

La which is a rare earth metal, Ba and Sr which are alkali earth metals, and Bi which is in a 5B group of the periodic system are possible to add, if necessary, in order to increase the mechanical strength of the gold alloy wire for the bonding wire and the work hardening ability of free-air ball, raise the re-crystallizing temperature, and lower the height of loop of the gold alloy wire. However, even though the amount of at least one of La, Ba, Sr, and Bi is less than 30 ppm, it may not obtain a predetermined effect. Meanwhile, when the amount of at least one of La, Ba, Sr, and Bi is larger than 100 ppm, a quantity of oxides is generated on the surface of free-air ball during the bonding of balls, and large shrinkage holes, which do not contribute to the bonding, are formed at the bottom-center of the free-air ball. Accordingly, the initial bonding ability of the ball bonding is lowered. For this reason, it is not preferable that the amount of at least one of La, Ba, Sr, and Bi be less than 30 ppm and larger than 100 ppm. Accordingly, the amount of at least one of La, Ba, Sr, and Bi is set within the range of 30 to 100 ppm.

(g) Ag:

Even though Ag of 1 to 10 ppm is contained, it has little influence on the properties. Accordingly, Ag is added, if necessary. However, when the amount of Ag is over 10 ppm, the initial bonding ability tends to be lowered. Therefore, it is not preferable that the amount of Ag be over 10 ppm.

[II] mechanical Property

All of the gold alloy wires for the bonding wire containing the above-described component composition have high initial bonding ability, high bonding reliability, high roundness of a compression ball, high straightness, high resin flowability resistance, and low specific resistance. However, when manufacturing the gold alloy wire for the bonding wire so as to satisfy the conditions of $E \geq 75$ GPa, $(\sigma_{0.2}/E) \geq 2.2 \times 10^{-3}$, and $2\% \leq E_L \leq 10\%$ by defining 0.2% proof strength (Pa) of the gold alloy wire as $\sigma_{0.2}$, Young's modulus (Pa) as E, and fracture elongation percentage as $E_L$, all of the gold alloy wires for the bonding wire containing the above-described component composition have higher straightness and higher resin flowability resistance.

The reason is as follows;

In a case of $E < 75$ GPa, that is, when the Young's modulus is low, the bonded gold alloy wire largely flows by the resin (that is, the resin flow is large) during the molding after the wire bonding, thereby the contact frequency and short frequency of the gold alloy wires adjacent to each other increase. Therefore, the yield ratio of semiconductor chips is reduced. When $\sigma_{0.2}/E$ is $2.2 \times 10^{-3}$ and more, the straightness rapidly is improved, and when the fracture elongation percentage is less than 2%, the residual distortion of the gold alloy wire after drawing the wire resides after annealing and the straightness is low. In addition, when the fracture elongation percentage is higher than 10%, Most of them satisfies the conditions of $E < 75$ GPa and $(\sigma_{0.2}/E) < 2.2 \times 10^{-3}$. Therefore, the straightness is reduced or the resin flow increases.

According to the invention, the fracture elongation percentage $E_L$ (%), the 0.2% proof strength $\sigma_{0.2}$ (Pa), and the Young's modulus (Pa) of the gold alloy wire for the bonding wire are measured by tensioning the gold alloy wire up to be fractured by a tension tester in the conditions of the distance between gauge points: 100 mm and a tension velocity: 10 mm/minute at a room temperature.

Here, strain and tension stress are defined as follows. Strain = the elongation (mm) of the gold alloy wire for the bonding wire / 100 mm, and tension stress (Pa) = tension load (N) / initial sectional area ($m^2$) of the gold alloy wire for the bonding wire. In addition, the fracture elongation percentage $E_L$ (%), the 0.2% proof strength $\sigma_{0.2}$ (Pa), and the Young's modulus (Pa) are defined as follows. The fracture elongation percentage $E_L$ (%) = strain when the gold alloy wire is fractured $\times$ 100 = [elongation (mm) when the gold alloy wire is fractured / 100 (mm)] $\times$ 100. The 0.2% proof

strength $\sigma_{0.2}$ (Pa): tension stress (Pa) in applying a permanent deformation of 0.2% to the gold alloy wire for the bonding wire. In addition, the Young's modulus (Pa): the ratio of tension stress and strain, that is, tension stress (Pa) / strain, in the range where tension stress and strain are in direct proportion.

EFFECTS OF THE INVENTION

As described above, the gold alloy wire for the bonding wire according to the invention has excellent initial bonding ability, excellent bonding reliability, excellent roundness of a compression ball, excellent straightness, excellent resin flowability resistance, and low specific resistance. Accordingly, when the gold alloy wire is used in bonding processes, it is possible to improve the yield ratio of semiconductor devices. As a result, the gold alloy wire for the bonding wire according to the invention has especially excellent effects in an industry.

BEST MODE FOR CARRING OUT THE INVENTION

A gold alloy wire having a wire diameter: 19 $\mu$m was manufactured by a drawing process a gold alloy wire material having a wire diameter: 50 $\mu$m and having component compositions indicated in Tables 1 to 3 at a reduction ratio by one die of 4.8%. Further, gold alloy wires for a bonding wire according to the invention (hereinafter, referred to as wires according to the invention) 1 to 34, comparative gold alloy wires for a bonding wire (hereinafter, referred to as comparative wires) 1 to 20, and the related art gold alloy wire for a bonding wire (hereinafter, referred to as the related art wire) 1 were manufactured by annealing the gold alloy wire at temperature indicated in Tables 4 to 6, and taken-out by an immediate spool of radius: 50 mm. Here, in the annealing and winding process, the radii of all of sheaves (pulleys) using for changing paths of the wires are 9 mm. A fracture elongation percentage $E_L$, Young's modulus (Pa) E, and 0.2% proof strength (Pa) $\sigma_{0.2}$ were measured by winding by a spool having a radius of 25 mm by 2000 m the wire taken-out by the immediate spool and removing the tip of the wire by 15 m, and $\sigma_{0.2}$ / E was calculated. The results were indicated in Tables 4 to 6. Further, the specific resistances of the wires are measured, and the results of the measurement were indicated in Tables 4 to 6. The number of samples is five in each of the measurement, thereby obtaining an average value. Resistances ($\Omega$) of the samples were measured by a digital multimeter in the conditions of the distance between gauge points: 500 mm at a room temperature, and the specific resistances of the wires were obtained with the following equation.

$$\text{Specific resistance } (\mu\Omega cm) = \text{resistance } (\Omega) \times \text{cross-sectional area } (cm^2) \text{ / } 50(cm) \times 10^6$$

The wires 1 to 34 according to the invention, the comparative wires 1 to 20, and the related art wire 1 having the component compositions indicated in Tables 1 to 3 and the mechanical properties indicated in Tables 4 to 6 were set in wire bond (maxam plus) manufactured by Kulicke & Soffa, and the bonding was performed on the substrate in which IC chips of the semiconductor were mounted under the conditions of heating temperature: 150°C, the length of loop: 5 mm, the height of loop: 220 $\mu$m, the diameter of a compression ball: 34 $\mu$m, and the height of the compression ball: 8 $\mu$m. The straightness, initial bonding ability, and roundness of the compression ball with respect to the wires 1 to 34 according to the invention, the comparative wires 1 to 20, and the related art wire 1 were estimated by following measurements.
Straightness Estimation:
10000 loops were manufactured at a pad pitch distance of 45 $\mu$m with respect to each of the samples, and_the number (contacting number) of places for contacting between the neighboring loops was measured. Accordingly, the straightness was estimated by indicating the results in Tables 4 to 6.
Initial Bondability Estimation:
10000 loops attached to each of the samples were manufactured, and the number (number of ball lifts) of times that the compression ball is not bonded to the Al pad during the bonding of balls was measured. Accordingly, the initial bonding ability was estimated by indicating the results in Tables 4 to 6.
Compression Ball Roundness Estimation:
By observing 100 compression balls with respect to each of the samples, when all of them are good, it indicates as "O", and even though one bad exists, it indicates as "x". Accordingly, the roundness was estimated by indicating the results in Tables 4 to 6.
Bonding Reliability Estimation:
After holding for 1000 hours in air of 150°C, 100 proof tests with respect to each sample were conducted by hanging a tool on a bending part (kink) of the loop directly on the compression ball. The fracture in the proof tests is referred to as a fracture (ball lift) in the bonding interface of the compression ball and Al pad. By observing the compression balls, when all the fractures were occurred in a neck, it was estimated as "O", and even though one ball lift exists, it was estimated as "x".

Further, the height of loop and the resin flowability resistance with respect to the wires 1 to 34 according to the invention having the component compositions indicated in Tables 1 to 3 and the mechanical properties indicated in Tables 4 to 6, the comparative wires 1 to 20, and the related art wire 1 were estimated.

Height of Loop:

The wires 1 to 34 according to the invention, the comparative wires 1 to 20, and the related art wire 1 having the component compositions indicated in Tables 1 to 3 and the mechanical properties indicated in Tables 4 to 6 were set in the wire bond (maxam plus) manufactured by Kulicke & Soffa, and the looping were mounted was performed under the conditions of the diameter of the compression ball: 34 μm, the height of the compression ball: 8 μm, and the length of loop: 1 mm without doing reverse. The highest part of the loop and the height of the area of Al pad were measured by a light microscope, and the difference of the highest part of the loop and the height of the area of Al pad was obtained as the height of loop. Accordingly, the height of loop was estimated by indicating the results in Tables 4 to 6.

Resin Flowability Resistance:

After sealing with an epoxy resin the substrate in which the bonded IC chips of the semiconductor were mounted under the condition of the length of loop: 3.5 mm by using a molding apparatus, the inside of the semiconductor chip was X-ray projected by using a soft X-ray non-destruction inspection system and the flowing rates where the maximum portion of the wire flow were measured at 20 times. By dividing the average value of the measured flow rates by the length of loop, the obtained value (%) was defined as a resin flow, and the resin flow was measured. Accordingly, the resin flowability resistance was estimated by indicating the results in Tables 4 to 6.

## Table 1

Component Composition of Gold Alloy Wire (Mass ppm)

| Wire | Pt | Pd | Ir | Ca | Be | Eu | La | Ba | Sr | Bi | Ag | Au |
|---|---|---|---|---|---|---|---|---|---|---|---|---|
| 1 | 500 | - | 50 | 70 | 10 | 60 | - | - | - | - | - | Balance |
| 2 | 800 | - | 50 | 70 | 10 | 60 | - | - | - | - | - | Balance |
| 3 | 980 | - | 50 | 70 | 10 | 60 | - | - | - | - | - | Balance |
| 4 | - | 500 | 50 | 70 | 10 | 60 | - | - | - | - | - | Balance |
| 5 | - | 800 | 50 | 70 | 10 | 60 | - | - | - | - | - | Balance |
| 6 | - | 980 | 50 | 70 | 10 | 60 | - | - | - | - | - | Balance |
| 7 | 250 | 250 | 50 | 70 | 10 | 60 | - | - | - | - | - | Balance |
| 8 | 400 | 400 | 50 | 70 | 10 | 60 | - | - | - | - | - | Balance |
| 9 | 490 | 490 | 50 | 70 | 10 | 60 | - | - | - | - | - | Balance |
| 10 | 400 | 400 | 1 | 70 | 10 | 60 | - | - | - | - | - | Balance |
| 11 | 400 | 400 | 100 | 70 | 10 | 60 | - | - | - | - | - | Balance |
| 12 | 400 | 400 | 50 | 32 | 10 | 60 | - | - | - | - | - | Balance |
| 13 | 400 | 400 | 50 | 100 | 10 | 60 | - | - | - | - | - | Balance |
| 14 | 400 | 400 | 50 | 70 | - | 60 | - | - | - | - | - | Balance |
| 15 | 400 | 400 | 50 | 70 | 20 | 60 | - | - | - | - | - | Balance |
| 16 | 400 | 400 | 50 | 70 | 10 | 32 | - | - | - | - | - | Balance |
| 17 | 400 | 400 | 50 | 70 | 10 | 100 | - | - | - | - | - | Balance |
| 18 | 400 | 400 | 50 | 70 | 10 | 60 | 30 | - | - | - | - | Balance |
| 19 | 400 | 400 | 50 | 70 | 10 | 60 | 60 | - | - | - | - | Balance |
| 20 | 400 | 400 | 50 | 70 | 10 | 60 | 100 | - | - | - | - | Balance |

The present invention

## Table 2

Component Composition of Gold Alloy Wire (Mass ppm)

| | Wire | Pt | Pd | Ir | Ca | Be | Eu | La | Ba | Sr | Bi | Ag | Au |
|---|---|---|---|---|---|---|---|---|---|---|---|---|---|
| The present invention | 21 | 400 | 400 | 50 | 70 | 10 | 60 | - | 30 | - | - | - | Balance |
| | 22 | 400 | 400 | 50 | 70 | 10 | 60 | - | 60 | - | - | - | Balance |
| | 23 | 400 | 400 | 50 | 70 | 10 | 60 | - | 100 | - | - | - | Balance |
| | 24 | 400 | 400 | 50 | 70 | 10 | 60 | - | - | 30 | - | - | Balance |
| | 25 | 400 | 400 | 50 | 70 | 10 | 60 | - | - | 60 | - | - | Balance |
| | 26 | 400 | 400 | 50 | 70 | 10 | 60 | - | - | 100 | - | - | Balance |
| | 27 | 400 | 400 | 50 | 70 | 10 | 60 | - | - | - | 30 | - | Balance |
| | 28 | 400 | 400 | 50 | 70 | 10 | 60 | - | - | - | 60 | - | Balance |
| | 29 | 400 | 400 | 50 | 70 | 10 | 60 | - | - | - | 100 | - | Balance |
| | 30 | 400 | 400 | 50 | 70 | 10 | 60 | - | - | - | - | 1 | Balance |
| | 31 | 400 | 400 | 50 | 70 | 10 | 60 | - | - | - | - | 5 | Balance |
| | 32 | 400 | 400 | 50 | 70 | 10 | 60 | - | - | - | - | 10 | Balance |
| | 33 | 400 | 400 | 50 | 70 | 10 | 60 | - | - | - | - | - | Balance |
| | 34 | 400 | 400 | 50 | 70 | 10 | 60 | - | - | - | - | - | Balance |
| Comparative | 1 | 300* | - | 50 | 70 | 10 | 60 | - | - | - | - | - | Balance |
| | 2 | 1500* | - | 50 | 70 | 10 | 60 | - | - | - | - | - | Balance |
| | 3 | - | 300* | 50 | 70 | 10 | 60 | - | - | - | - | - | Balance |
| | 4 | - | 1500* | 50 | 70 | 10 | 60 | - | - | - | - | - | Balance |
| | 5 | 150* | 150* | 50 | 70 | 10 | 60 | - | - | - | - | - | Balance |
| | 6 | 750* | 750* | 50 | 70 | 10 | 60 | - | - | - | - | - | Balance |

* means a value out of the range of the present invention

Table 3

| Wire | | Component Composition of Gold Alloy Wire (Mass ppm) | | | | | | | | | | | |
|---|---|---|---|---|---|---|---|---|---|---|---|---|---|
| | | Pt | Pd | Ir | Ca | Be | Eu | La | Ba | Sr | Bi | Ag | Au |
| Comparative | 7 | 400 | 400 | -* | 70 | 10 | 60 | - | - | - | - | - | Balance |
| | 8 | 400 | 400 | 150* | 70 | 10 | 60 | - | - | - | - | - | Balance |
| | 9 | 400 | 400 | 50 | 20* | 10 | 60 | - | - | - | - | - | Balance |
| | 10 | 400 | 400 | 50 | 120* | 10 | 60 | - | - | - | - | - | Balance |
| | 11 | 400 | 400 | 50 | 70 | 30* | 60 | - | - | - | - | - | Balance |
| | 12 | 400 | 400 | 50 | 70 | 10 | 20* | - | - | - | - | - | Balance |
| | 13 | 400 | 400 | 50 | 70 | 10 | 120* | - | - | - | - | - | Balance |
| | 14 | 400 | 400 | 50 | 70 | 10 | 60 | 120* | - | - | - | - | Balance |
| | 15 | 400 | 400 | 50 | 70 | 10 | 60 | - | 120* | - | - | - | Balance |
| | 16 | 400 | 400 | 50 | 70 | 10 | 60 | - | - | 120* | - | - | Balance |
| | 17 | 400 | 400 | 50 | 70 | 10 | 60 | - | - | - | 120* | - | Balance |
| | 18 | 400 | 400 | 50 | 70 | 10 | 60 | - | - | - | - | 20* | Balance |
| | 19 | 400 | 400 | 50 | 70 | 10 | 60 | - | - | - | - | - | Balance |
| | 20 | 400 | 400 | 50 | 70 | 10 | 60 | - | - | - | - | - | Balance |
| The Related Art 1 | | 400 | 400 | 50 | 20* | 5 | 20* | - | - | - | - | - | Balance |

*: means a value out of the range of the present invention

## Table 4

| Wire | Annealing Temperature (°C) | Mechanical Property | | | | The number of contacts (Piece) | The Number of ball lifts (Piece) | Roundness of Compression Ball | Bonding Reliability | Resin flowability (%) | Height of Loop (μm) | Specific resistance (μΩcm) |
| | | Fracture Elongation Percentage $E_L$ (%) | Young's modulus E (GPa) | $\sigma_{0.2}/E$ × 10⁻³ | $\sigma_{0.2}$ (MPa) | | | | | | | |
|---|---|---|---|---|---|---|---|---|---|---|---|---|
| 1 | 525 | 4.1 | 89 | 2.4 | 217 | 19 | 0 | O | O | 2.7 | 73 | 2.4 |
| 2 | 526 | 4.1 | 89 | 2.5 | 226 | 18 | 0 | O | O | 2.4 | 71 | 2.4 |
| 3 | 524 | 4.2 | 89 | 2.5 | 226 | 19 | 0 | O | O | 2.6 | 75 | 2.4 |
| 4 | 524 | 4.2 | 89 | 2.5 | 219 | 21 | 0 | O | O | 2.5 | 75 | 2.4 |
| 5 | 526 | 4.2 | 88 | 2.6 | 225 | 23 | 0 | O | O | 2.7 | 73 | 2.4 |
| 6 | 525 | 4.1 | 88 | 2.4 | 211 | 18 | 0 | O | O | 2.7 | 71 | 2.4 |
| 7 | 527 | 4.1 | 87 | 2.5 | 222 | 22 | 0 | O | O | 2.5 | 74 | 2.4 |
| 8 | 527 | 4.3 | 90 | 2.5 | 225 | 24 | 0 | O | O | 2.7 | 74 | 2.4 |
| 9 | 526 | 4.1 | 90 | 2.5 | 224 | 20 | 0 | O | O | 2.6 | 75 | 2.4 |
| 10 | 527 | 4.3 | 86 | 2.5 | 218 | 23 | 0 | O | O | 2.4 | 80 | 2.4 |
| 11 | 525 | 4.2 | 88 | 2.6 | 228 | 23 | 0 | O | O | 2.4 | 75 | 2.4 |
| 12 | 513 | 4.1 | 80 | 2.3 | 184 | 30 | 0 | O | O | 3.1 | 77 | 2.4 |
| 13 | 536 | 4.0 | 93 | 2.7 | 253 | 6 | 0 | O | O | 2.2 | 69 | 2.4 |
| 14 | 536 | 4.2 | 89 | 2.5 | 222 | 21 | 0 | O | O | 2.4 | 65 | 2.4 |
| 15 | 517 | 4.1 | 94 | 2.8 | 263 | 11 | 0 | O | O | 2.1 | 85 | 2.4 |
| 16 | 514 | 4.2 | 81 | 2.4 | 197 | 24 | 0 | O | O | 2.6 | 79 | 2.4 |
| 17 | 534 | 4.3 | 93 | 2.8 | 262 | 7 | 0 | O | O | 2.0 | 69 | 2.4 |
| 18 | 527 | 4.1 | 88 | 2.4 | 215 | 20 | 0 | O | O | 2.4 | 72 | 2.4 |

The present invention

Table 5

| | Wire | Annealing Temperature (°C) | Mechanical Property | | | | The number of contacts (Piece) | The Number of ball lifts (Piece) | Roundness of Compression Ball | Bonding Reliability | Resin flowability (%) | Height of Loop (μm) | Specific resistance (μΩcm) |
|---|---|---|---|---|---|---|---|---|---|---|---|---|---|
| | | | Fracture Elongation Percentage $E_L$(%) | Young's modulus E(GPa) | $\sigma_{0.2}/E$ ×10⁻³ | $\sigma_{0.t}$ (MPa) | | | | | | | |
| The present invention | 19 | 530 | 4.1 | 93 | 2.7 | 248 | 10 | 0 | O | O | 2.4 | 71 | 2.4 |
| | 20 | 534 | 4.1 | 99 | 2.7 | 270 | 14 | 0 | O | O | 2.2 | 66 | 2.4 |
| | 21 | 527 | 4.2 | 86 | 2.5 | 213 | 16 | 0 | O | O | 2.3 | 71 | 2.4 |
| | 22 | 531 | 4.1 | 92 | 2.7 | 248 | 19 | 0 | O | O | 2.3 | 72 | 2.4 |
| | 23 | 534 | 4.1 | 98 | 2.8 | 271 | 6 | 0 | O | O | 2.0 | 68 | 2.4 |
| | 24 | 527 | 4.1 | 89 | 2.5 | 224 | 19 | 0 | O | O | 2.4 | 71 | 2.4 |
| | 25 | 531 | 4.4 | 93 | 2.6 | 245 | 12 | 0 | O | O | 2.4 | 69 | 2.4 |
| | 26 | 534 | 4.3 | 97 | 2.8 | 276 | 7 | 0 | O | O | 1.9 | 68 | 2.4 |
| | 27 | 527 | 4.2 | 89 | 2.6 | 227 | 18 | 0 | O | O | 2.4 | 75 | 2.4 |
| | 28 | 532 | 4.4 | 92 | 2.6 | 239 | 11 | 0 | O | O | 2.1 | 70 | 2.4 |
| | 29 | 535 | 4.3 | 96 | 2.8 | 269 | 10 | 0 | O | O | 1.9 | 68 | 2.4 |
| | 30 | 524 | 4.3 | 90 | 2.5 | 224 | 22 | 0 | O | O | 2.4 | 74 | 2.4 |
| | 31 | 525 | 4.3 | 89 | 2.5 | 224 | 20 | 0 | O | O | 2.6 | 75 | 2.4 |
| | 32 | 525 | 4.2 | 89 | 2.6 | 232 | 16 | 0 | O | O | 2.5 | 74 | 2.4 |
| | 33 | 485 | 2.0 | 99 | 3.0 | 296 | 31 | 0 | O | O | 2.1 | 74 | 2.4 |
| | 34 | 542 | 10.0 | 80 | 2.2 | 176 | 22 | 0 | O | O | 3.2 | 72 | 2.4 |
| Comparative | 1 | 526 | 4.2 | 88 | 2.5 | 220 | 18 | 0 | O | × | 2.4 | 75 | 2.3 |
| | 2 | 526 | 4.1 | 87 | 2.5 | 218 | 24 | 0 | O | O | 2.7 | 71 | 2.5 |

**Table 6**

| Wire | | Annealing Temperature (°C) | Mechanical Property | | | | The number of contacts (Piece) | The Number of ball lifts (Piece) | Roundness of Compression Ball | Bonding Reliability | Resin flowability (%) | Height of Loop (μm) | Specific resistance (μΩcm) |
|---|---|---|---|---|---|---|---|---|---|---|---|---|---|
| | | | Fracture Elongation Percentage $E_L$ (%) | Young's modulus E (GPa) | $\sigma_{0.2}/E$ × $10^{-3}$ | $\sigma_{0.2}$ (MPa) | | | | | | | |
| Comparative | 3 | 525 | 4.4 | 86 | 2.6 | 224 | 20 | 0 | ○ | × | 2.5 | 74 | 2.3 |
| | 4 | 526 | 4.3 | 89 | 2.6 | 226 | 15 | 0 | ○ | ○ | 2.6 | 75 | 2.5 |
| | 5 | 526 | 4.3 | 86 | 2.5 | 212 | 17 | 0 | ○ | × | 2.5 | 75 | 2.3 |
| | 6 | 525 | 4.1 | 87 | 2.5 | 218 | 22 | 0 | ○ | ○ | 2.3 | 71 | 2.5 |
| | 7 | 524 | 4.2 | 87 | 2.5 | 212 | 19 | 0 | × | ○ | 2.4 | 82 | 2.4 |
| | 8 | 526 | 4.2 | 87 | 2.5 | 221 | A part of Al pad is damaged | | | | | | 2.4 |
| | 9 | 516 | 4.4 | 78 | 2.1* | 167 | 156 | 18 | ○ | ○ | 4.3 | 83 | 2.4 |
| | 10 | 535 | 4.3 | 94 | 2.7 | 254 | 7 | 5 | ○ | ○ | 2.1 | 61 | 2.4 |
| | 11 | 514 | 4.3 | 93 | 2.8 | 260 | 12 | 3 | × | ○ | 2.6 | 83 | 2.4 |
| | 12 | 514 | 4.3 | 80 | 2.1* | 171 | 121 | 15 | ○ | ○ | 3.5 | 84 | 2.4 |
| | 13 | 534 | 4.1 | 95 | 2.9 | 270 | 8 | 4 | ○ | ○ | 2.1 | 61 | 2.4 |
| | 14 | 535 | 4.0 | 99 | 2.8 | 275 | 12 | 3 | ○ | ○ | 2.3 | 68 | 2.4 |
| | 15 | 535 | 4.1 | 97 | 2.8 | 270 | 8 | 4 | ○ | ○ | 2.0 | 70 | 2.4 |
| | 16 | 534 | 4.1 | 98 | 2.8 | 273 | 11 | 3 | ○ | ○ | 1.9 | 67 | 2.4 |
| | 17 | 536 | 4.0 | 98 | 2.7 | 265 | 7 | 3 | ○ | ○ | 2.1 | 68 | 2.4 |
| | 18 | 526 | 4.1 | 89 | 2.6 | 229 | 16 | 2 | ○ | ○ | 2.5 | 73 | 2.4 |
| | 19 | 305 | 1.5* | 105 | 3.3 | 345 | 258 | 0 | ○ | ○ | 1.9 | 71 | 2.4 |
| | 20 | 548 | 12.0* | 74* | 2.1* | 158 | 171 | 0 | ○ | ○ | 4.2 | 71 | 2.4 |
| The Related Art 1 | | 515 | 4.3 | 74* | 2.1* | 158 | 382 | 45 | ○ | ○ | 4.5 | 87 | 2.4 |

*: means a value out of the range of the present invention

It can be understood from the results indicated in Tables 1 to 6 that the wires 1 to 34 according to the invention have low specific resistance, excellent straightness, initial bonding ability, roundness of the compression ball, bonding reliability, and resin flowability resistance, and more particularly, with respect to the excellent straightness, initial bonding ability, roundness of the compression ball, bonding reliability, and resin flowability resistance, the comparative wires 1 to 20 and the related art wire 1 have a defect of at least one of the above-described properties.

**Claims**

1. A gold alloy wire for a bonding wire that has high initial bonding ability, high bonding reliability, high roundness of a compression ball, high straightness, high resin flowability resistance, and low specific resistance, the gold alloy wire having:

   a component composition comprising one or more of Pt and Pd of 500 to less than 1000 ppm in total, Ir of 1 to 100 ppm, Ca of more than 30 to 100 ppm, Eu of more than 30 to 100 ppm, and a balance being Au and inevitable impurities.

2. A gold alloy wire for a bonding wire that has high initial bonding ability, high bonding reliability, high roundness of a compression ball, high straightness, high resin flowability resistance, and low specific resistance, the gold alloy wire having:

   a component composition comprising one or more of Pt and Pd of 500 to less than 1000 ppm in total, Ir of 1 to 100 ppm, Ca of more than 30 to 100 ppm, Eu of more than 30 to 100 ppm, Be of 0.1 to 20 ppm, and a balance being Au and inevitable impurities.

3. A gold alloy wire for a bonding wire that has high initial bonding ability, high bonding reliability, high roundness of a compression ball, high straightness, high resin flowability resistance, and low specific resistance, the gold alloy wire having:

   a component composition comprising one or more of Pt and Pd of 500 to less than 1000 ppm in total, Ir 1 to 100 ppm, Ca of more than 30 to 100 ppm, Eu of more than 30 to 100 ppm, Be of 0.1 to 20 ppm, one or more of La, Ba, Sr, and Bi of 30 to 100 ppm in total, and a balance being Au and inevitable impurities.

4. The gold alloy wire for the bonding wire that has high initial bonding ability, high bonding reliability, high roundness of a compression ball, high straightness, high resin flowability resistance, and low specific resistance according to any one of claims 1 to 3, further comprising:

   Ag of 1 to 10 ppm.

5. The gold alloy wire for the bonding wire that has high initial bonding ability, high bonding reliability, high roundness of a compression ball, high straightness, high resin flowability resistance, and low specific resistance according to any one of claims 1 to 4,
   wherein, when 0.2% proof strength (Pa) of the gold alloy wire for the bonding wire is $\sigma_{0.2}$, Young's modulus (Pa) is E, and fracture elongation percentage is $E_L$, the following equations are satisfied

$$E \geq 75 \text{ GPa};$$

$$(\sigma_{0.2}/E) \geq 2.2 \times 10^{-3};$$

   and

$$2\% \leq E_L \leq 10\%.$$

<div align="center">

**INTERNATIONAL SEARCH REPORT**

</div>

| International application No. |
|---|
| PCT/JP2006/311525 |

| A. CLASSIFICATION OF SUBJECT MATTER |
|---|
| *H01L21/60*(2006.01)i, *C22C5/02*(2006.01)i |
| According to International Patent Classification (IPC) or to both national classification and IPC |

| B. FIELDS SEARCHED |
|---|
| Minimum documentation searched (classification system followed by classification symbols) |
| H01L21/60, C22C5/02 |

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| A | JP 8-109425 A  (Tanaka Denshi Kogyo Kabushiki Kaisha), 30 April, 1996 (30.04.96), (Family: none) | 1-5 |
| A | JP 10-275820 A  (Tanaka Denshi Kogyo Kabushiki Kaisha), 13 October, 1998 (13.10.98), (Family: none) | 1-5 |
| A | JP 11-45899 A  (Sumitomo Metal Mining Co., Ltd.), 16 February, 1999 (16.02.99), (Family: none) | 1-5 |

| ☒ Further documents are listed in the continuation of Box C. | ☐ See patent family annex. |
|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 01 September, 2006 (01.09.06) | 12 September, 2006 (12.09.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

| International application No. |
| --- |
| PCT/JP2006/311525 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 11-45900 A (Sumitomo Metal Mining Co., Ltd.), 16 February, 1999 (16.02.99), (Family: none) | 1-5 |
| A | JP 11-45901 A (Sumitomo Metal Mining Co., Ltd.), 16 February, 1999 (16.02.99), (Family: none) | 1-5 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8109425 A